(19) Europäisches Patentamt
European Patent Office
Office européen des brevets

(11) **EP 3 872 449 B1**

(12) **EUROPEAN PATENT SPECIFICATION**

(45) Date of publication and mention
of the grant of the patent:
**24.04.2024 Bulletin 2024/17**

(21) Application number: **21167506.1**

(22) Date of filing: **26.07.2017**

(51) International Patent Classification (IPC):
**G01C 1/00** (2006.01)     **G01C 17/38** (2006.01)
**G01C 21/16** (2006.01)     **G01C 25/00** (2006.01)
**G01R 33/00** (2006.01)

(52) Cooperative Patent Classification (CPC):
**G01R 33/0035; G01C 1/00; G01C 17/38;
G01C 25/005**

(54) **METHOD AND SYSTEM FOR COMPENSATING FOR SOFT IRON MAGNETIC DISTURBANCES IN MULTIPLE HEADING REFERENCE SYSTEMS**

VERFAHREN UND SYSTEM ZUR KOMPENSATION MAGNETISCHER WEICHEISENSTÖRUNGEN IN MEHREREN KURSREFERENZSYSTEMEN

PROCÉDÉ ET SYSTÈME PERMETTANT DE COMPENSER LES PERTURBATIONS MAGNÉTIQUES DE FER DOUX DANS DES SYSTÈMES DE RÉFÉRENCE DE CAP

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.07.2016 US 201615223953
10.05.2017 US 201715592068**

(43) Date of publication of application:
**01.09.2021 Bulletin 2021/35**

(62) Document number(s) of the earlier application(s) in accordance with Art. 76 EPC:
**17183362.7 / 3 276 302**

(73) Proprietor: **Innovative Solutions & Support, Inc.
Exton, PA 19341 (US)**

(72) Inventors:
  • **ASKARPOUR, Shahram
    Media, 19063 (US)**
  • **HEDRICK, Geoffrey
    Malvern, 19355 (US)**

(74) Representative: **Mewburn Ellis LLP
Aurora Building
Counterslip
Bristol BS1 6BX (GB)**

(56) References cited:
**EP-A2- 2 677 275     US-A1- 2013 106 697**

**Description**

## CROSS-REFERENCE TO RELATED APPLICATIONS

The present application claims the benefit of U.S. Patent Application No. 15/223,953 filed on July 29, 2016, which is a continuation-in-part of U.S. Patent Application No. 14/928,715 filed on October 30, 2015, which is a divisional of U.S. Patent Application No. 13/529,894 filed June 21, 2012 (now, U.S. Patent No. 9,207,079). The present application also claims the benefit of U.S Patent Application No. 15/592,068 filed on May 10, 2017.

## FIELD OF THE INVENTION

The present invention relates to heading reference systems and particularly to such systems in which magnetic disturbances due to the presence of local soft iron effects can result in errors in magnetic heading determinations which affect the provision of a heading relative to magnetic north.

## BACKGROUND OF THE INVENTION

Traditionally in heading reference systems used for providing a heading relative to magnetic north, such as Attitude and Heading Reference Systems, Air Data and Attitude Heading Reference Systems, Inertial Navigation Systems, or Integrated Standby Systems of the type conventionally employed in aircraft, the heading gyro is periodically corrected by means of data from an external magnetometer that relies on the earth's magnetic field to provide a heading relative to magnetic north. However, the accuracy of such readings can significantly be affected by the presence of local soft iron, such as from local electric circuits on board the aircraft, resulting in meaningful errors in the calculation and ultimate display of the magnetic heading relative to true magnetic north. This can result in serious problems, such as with respect to the proper guidance of the aircraft along its designated flight path. Because of the seriousness of this problem, as well as the desire for a cost effective and efficient solution various attempts have been made to try and avoid these effects which, while helpful, have not totally achieved the objective. One such prior art attempt to try and avoid the effects of the local presence of soft iron which provides these undesirable magnetic disturbances, has involved carefully locating the external magnetometers in aircraft areas where there are minimal local magnetic disturbances present; however, this approach has not proved to be sufficiently cost effective and efficient since it involves locating the external magnetometers on the aircraft wings away from the other electrical devices which can cause such soft iron magnetic disturbances. Such an approach introduces a significant cost due to the presence of such factors as increased installation costs as well as the increased cost of additional units.

In addition, although the use of multiple reference systems installed at different locations of a vehicle can alleviate some of the soft iron effects by providing redundancy through the ability to obtain supplemental heading measurements, it remains a highly costly solution in terms of installation and maintenance. Furthermore, such multiple reference systems commonly operate independently and typically disable the unit that is exhibiting erroneous measurements due to magnetic disturbances instead of compensating by taking into account the measurements of the remaining systems.

This problem of soft iron magnetic disturbances affecting the provision of a correct heading relative to magnetic north while significant with respect to aircraft guidance is not limited to aircraft instruments and is important as well in the guidance of other vehicles which utilize heading reference systems for guidance. Thus, the same problem can occur in any vehicle and any inertial system that normally requires a source of heading that can be subject to variations as a result of local electric/magnetic field changes. Consequently, it is believed that the present invention is applicable to any magnetic heading indication system where disturbances of local soft iron can result in errors in magnetic heading determinations.

Prior art attempts at solving such problems, in applicant's view, are not as efficient or cost effective as the claimed invention and, thus, have not adequately solved the problem. Examples of other such prior art attempts, which applicant believes do not satisfactorily solve the problem, are described, by way of example, in United States Patent Nos. 4,414,753, entitled "Process for Compensating the Magnetic Disturbances In The Determination of a Magnetic Heading and Devices for Carrying Out This Process"; 5,737,226, entitled "Vehicle Compass System With Automatic Calibration"; and 5,878,370, entitled "Vehicle Compass System With Variable Resolution". Other prior art attempts at compensating for errors in the measurement of magnetometers, which applicant also believes do not satisfactorily solve the problem presented here, are described, by way of example in United States Patent Nos. 5,682,335, entitled "Method and Device for Simultaneous Identification and Correction of Errors in the Measurements of a Magnetometer"; 7,146,740, entitled "Methods and Apparatus for Automatic Magnetic Compensation"; 6,860,023, entitled "Methods and Apparatus for Automatic Magnetic Compensation"; 5,990,679, entitled "Method Using Corrective Factors for Determining a Magnetic Gradient"; 5,321,631, entitled "Method and Self-Contained System for Harmonizing Equipments On Board a Vehicle Using Means of Measuring the Earth's Gravitational and Magnetic Fields"; 4,843,865, entitled "Method of Calibrating a Compass Heading"; 4,733,179, entitled "Method of Determining an Interference-Magnetic Field in a Motor Vehicle Provided with an Electronic Compass"; and 4,005,358, entitled "Magnetometer with Out-of-Phase Correction".

EP 2 677 275 A2 discloses a method and system for compensating for significant soft iron magnetic disturbances in a heading reference system, such as an aircraft heading reference system, such as an integrated standby unit, or a vehicle inertial system. The method and system provides a heading correction signal to the heading reference system when a detected difference in value between a gyro heading relative to magnetic north and a magnetometer reading during a defined measurement period exceeds a predetermined acceptable threshold value of change, such as one based on the expected gyro drift over that period. Upon receipt of the heading correction signal, the gyro heading is adjusted to maintain an accurate heading relative to true magnetic north. If this threshold value is not exceeded, then the magnetometer reading is used for the heading value. This method is iteratively repeated in order to continually maintain an accurate heading and may be employed for each heading measurement axis.

Thus, it is believed that there is a need for an efficient and cost effective solution for avoiding the effects of local soft iron on magnetic heading calculations in magnetic heading reference systems whether in an aircraft or any other vehicle employing such a system for proper guidance.

## SUMMARY OF PARTICULAR EMBODIMENTS OF THE INVENTION

According to a first aspect of the present invention there is provided a system for compensating for soft iron magnetic disturbances in a heading reference system of a vehicle as specified in claim 1.

The system may optionally be as specified in any one of claims 2 to 8.

According to a second aspect of the present invention there is provided a method for compensating for soft iron magnetic disturbances in a heading reference system of a vehicle as specified in claim 9.

The method may optionally be as specified in any one of claims 10 to 13.

The above methods and systems of the present invention may be employed to improve the compensation of any magnetic indication heading reference system for the presence of soft iron magnetic disturbances which can result in errors in magnetic heading determinations, such as in aircraft systems, such as integrated standby units or other aircraft systems employing heading reference systems, as well as in any vehicle or inertial system that requires a source of heading that may be subject to significant variations as a result of local electric/magnetic field changes. Such systems may be employed as primary or secondary systems and, if desired, may utilize a Kalman filter to blend the gyro measurement with the magnetometer measurement, with the acceptable difference being dependent on the gyro error covariance.

Various benefits and features of the present invention may become apparent from the following detailed description considered in conjunction with the accompanying drawings. It is to be understood, however, that the drawings are designed solely for purposes of illustration and not as a definition of the limits of the invention for which reference should be made to the appended claims.

## BRIEF DESCRIPTION OF THE DRAWINGS

Further features of the invention, its nature and various advantages will be more apparent from the following detailed description of the embodiments, taken in conjunction with the accompanying drawings in which:

FIG. 1 is a flow chart in accordance with the method of the present invention which may be implemented in a heading reference system subject to soft iron magnetic disturbances.

FIG. 2 is a block diagram of a typical heading reference system, such as an improved integrated standby system employing a heading reference system, implementing the method of the present invention illustrated in FIG. 1.

FIG. 3 is a flow chart, similar to FIG. 1, in accordance with the method of the present invention, which may, alternatively, be implemented in the heading reference system of FIG. 2 and may be implemented alternatively in the heading systems of FIG. 4.

FIG. 4 is a block diagram of a vehicle navigation system including two integrated standby systems employing respective heading reference systems in accordance with some embodiments of the present invention.

FIG. 5 is a flow chart illustrating a process for correcting for the effects of soft iron in magnetometers given a dual installation of heading and reference systems of FIG. 4 in accordance with some embodiments of the present invention.

FIG. 6 is a flow chart illustrating a process for correcting for the effects of soft iron in magnetometers and calibrating magnetometers given a dual installation of heading and reference systems of FIG. 4 in accordance with some embodiments of the present invention.

## DETAILED DESCRIPTION OF EMBODIMENTS OF THE INVENTION

Navigation operations in vehicles require the use of heading and reference systems in order to obtain heading with respect to magnetic north and other navigation parameters. These systems are typically viewed as triaxial sensor systems that include gyroscopes, accelerometers and magnetometers and are capable of providing real-time orientation and direction information. As a result, these systems need to be reliable and accurate. However, the sensors commonly employed in the heading and reference systems are susceptible to different types of errors. For example, accelerometers can be adversely affected by sudden movements of the vehicle while gyroscopes only provide acceptable short-time stability due to the presence of a gyro drift attributed mainly to the initialization of the sensor and the subsequent integration of the measurements, thus resulting in unreliable measurements that can prove potentially dangerous for the operation of the vehicle. Furthermore, magnetometers are also susceptible to erroneous magnetic field measurements due to local magnetic disturbances. For example, the presence of ferrous materials (e.g., natural magnets) can cause constant hard iron disturbances that need to be accounted for during magnetometer readings. In addition, the presence of static and/or portable electrical circuits within the vehicle causes localized changes in the electromagnetic field which are reflected in the measurements of the magnetometers installed in the vicinity of the electrical circuits as soft iron disturbances. Such soft-iron disturbances can be dynamically changing and are of a non-linear nature. As a result, the magnetometers need to be periodically monitored and assessed for the presence of soft iron disturbances and subsequently calibrated in order to provide accurate heading measurements.

Accordingly, systems and methods are provided for periodically correcting for the effects of local soft iron on magnetic heading calculations in heading reference systems by detecting changes in both the magnetometer readings due to the presence of any soft iron magnetic disturbances and the gyro heading relative to magnetic north during a detection period. If the changes exceed a pre-defined threshold associated with an expected gyro drift the magnetometers are calibrated based on the gyro measurements.

Furthermore, the provided systems and methods can be employed in multiple installations of heading and reference systems (e.g., two or more) at different locations within a vehicle in order to identify localized soft-iron disturbances by measuring changes in the magnetic field during a detection period and subsequently detecting the heading and reference system responsible for exhibiting erroneous measurements and calibrating its internal magnetometers.

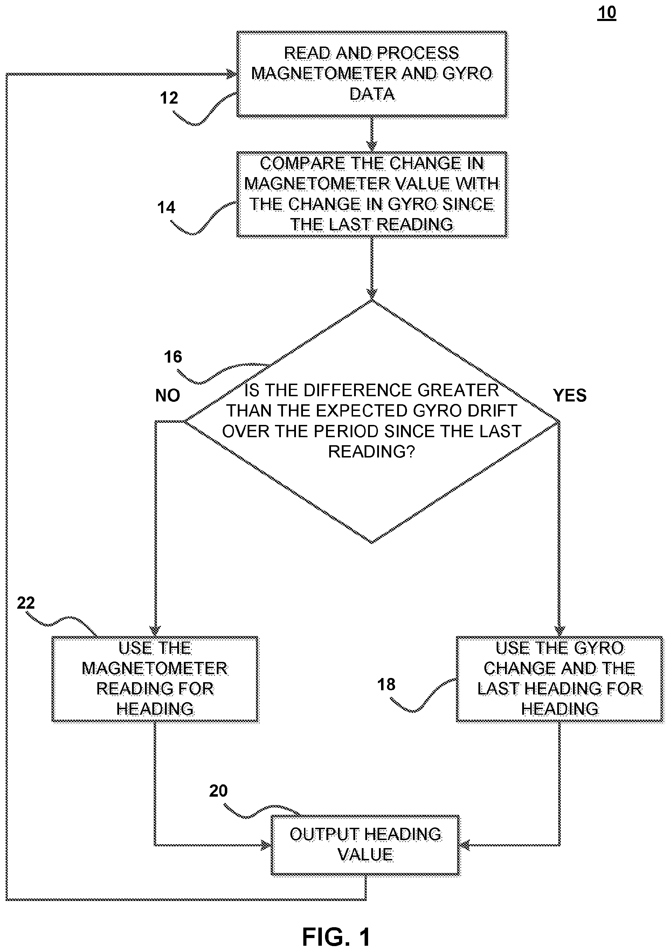

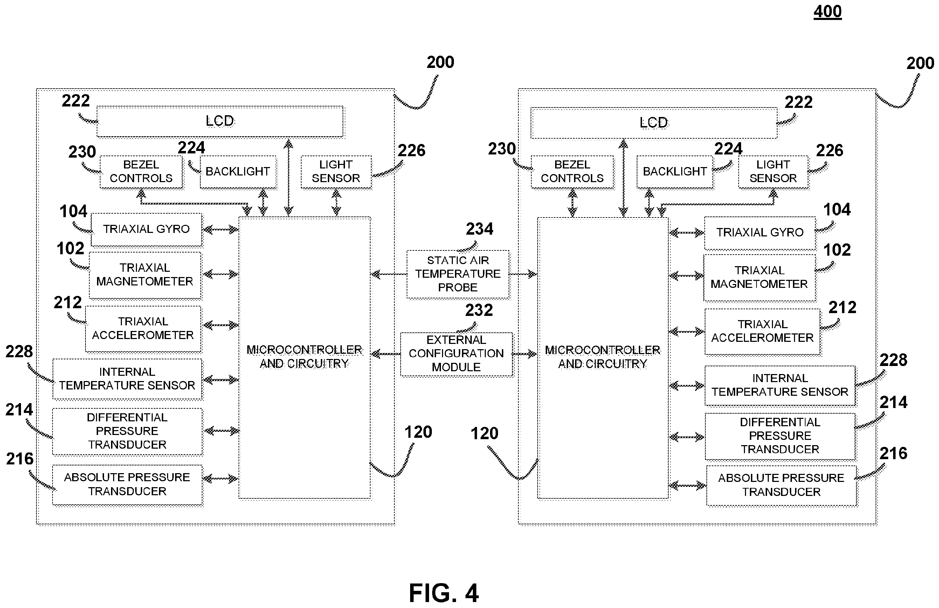

The following describes examples not forming part of the invention in more detail with reference to the accompanying figures. For example, the discussion below describes techniques using a single heading and reference system for correcting for the effects of soft iron on the magnetometers based on magnetic heading differences associated with a gyro drift with reference to Figures 1-3. Thereafter, the discussion describes embodiments, with reference to Figures 4-6, using dual installations of heading and reference systems for identifying and correcting localized soft-iron disturbances on the magnetometers that may use differences associated with a gyro drift.

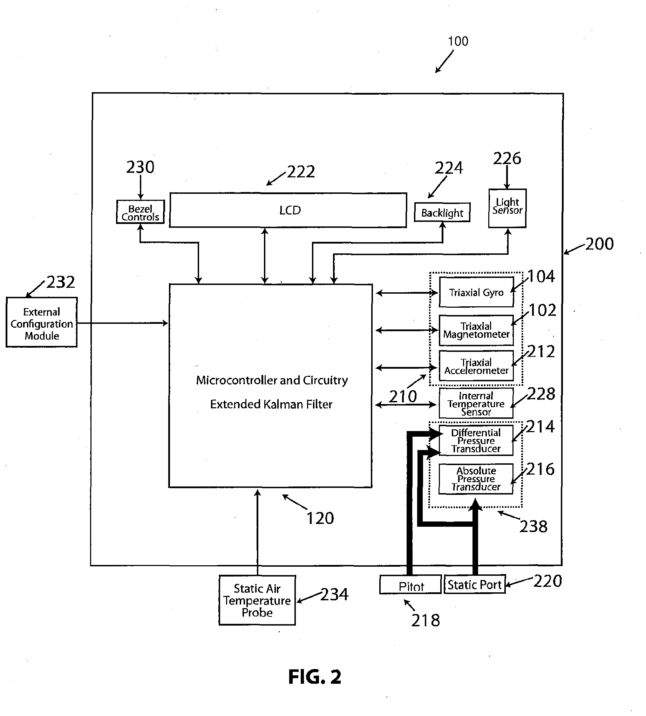

Referring now to the drawings in detail, and initially to FIG. 1, a flow chart is shown which illustrates a compensation method for minimizing the effects of soft iron magnetic disturbances in a heading reference system, such as the system 100 illustrated in FIG. 2. As will be described in greater detail hereinafter, the compensation method may be conventionally implemented in firmware or software housed in the conventional heading reference system 100 of the instrument, such as the integrated standby unit 200 illustrated in FIG. 2. The implementation of the compensation method in firmware or software may readily be accomplished by one of ordinary skill in the art once the presently preferred compensation method of the present invention is understood from reference to the following description of this method below.

As shown and preferred, FIG. 1 diagrammatically illustrates a flow chart depicted as an iterative control loop 10 for repetitively compensating for any defined significant changes in the accuracy of a heading system 100 due to soft iron magnetic disturbances, such as can occur from local electric circuits adjacent to the heading reference system 100. This is preferably accomplished, as will be described in greater detail hereinafter, from a comparison of the change in the reading of the magnetometer, illustrated as a triaxial magnetometer 102 in FIG. 2, associated with the heading reference system 100, with the reading of the heading reference system gyro, illustrated as a triaxial gyro 104 in FIG. 2, against an expected gyro drift over that measurement period since the prior reading.

As illustrated in FIG. 1, the steps involved in iteratively carrying out the compensation method are as follows. The output data from both the magnetometer 102 and the gyro 104 are read and processed to provide signals corresponding to any change in the value of the magnetometer 102 reading and the gyro 104 reading. This step is represented by block 12 in FIG. 1. These signals are then compared to determine the actual changes in these values against each other since the previous reading. This step is represented by block 14 in FIG. 1. A determination is then made if any detected difference in value from the previous reading exceeds a predetermined acceptable threshold value which is preferably defined as the expected gyro drift over the period since the prior reading. This step is represented in FIG. 1 by block 16. If as a result of this comparison the difference exceeds the expected gyro drift or acceptable threshold value, then, in accordance with the presently preferred compensation method of the present invention a corrected heading signal is provided which corresponds to the actual gyro change plus the last heading and this corrected heading signal is output to the heading reference system 100 to adjust the gyro heading to maintain accuracy. These steps are represented in FIG. 1 by blocks 18 and 20. On the other hand, if this detected difference does not exceed the predetermined acceptable threshold value, in other words, it is not greater than the expected gyro drift over this period, then the detected magnetometer 102 reading is used to provide the heading value for the gyro 104. These steps are represented by blocks 22 and 20 in FIG. 1. As previously mentioned, and as illustrated in the flow chart of FIG. 1, these steps continue to be iteratively periodically repeated in order to continue to maintain an accurate heading for the heading reference system 100 in the face of soft iron magnetic disturbances throughout the operation of the heading reference system 100.

The above described flow chart illustrated in FIG. 1 may be represented by the following algorithm:
In the case where:

k is a positive constant derived from expected gyro drift over the period $\Delta t$;

$\Delta MH$ is the change in magnetometer derived heading over the period $\Delta t$;

$\Delta GH$ is the change in gyro derived heading over the period $\Delta t$;

GH is the gyro derived heading at a specific time;

MH is the magnetometer derived heading at a specific time;

$$\Delta H = |\Delta MH - \Delta GH|;$$

Heading = fn(GH, MH) for $\Delta H \leq k$; and

Heading = GH and MH=MH+ $\Delta H$ for $\Delta H > k$.

As described above, this algorithm can be readily implemented in firmware or software, such as employed in the microprocessor 120 of the heading reference system 100, such as a Freescale microprocessor conventionally programmed in C. As noted above, the algorithm relies on the periodic correction of the heading gyro 104 only when the difference between the magnetometer 102 reading and the gyro 104 measurements is in the order of the expected gyro drift over the period since the last correction was made to the gyro 104.

Summarizing the above described compensation method, preferably the magnetometer data is read for each axis as well as the gyro data for each axis. The gyro data is converted from body to inertial coordinates. The rate of change of heading based on the magnetometer readings over time is determined. The rate of change of heading is compared with the inertial coordinate rate of change of yaw from the gyros. Then, in accordance with the method of the present invention, the algorithm records the difference in rates of change if this difference is greater than a predetermined threshold value and uses it as a bias to correct for the soft iron impact on the magnetometer. On the other hand, if this difference is not greater than the predetermined threshold value, the algorithm uses the actual magnetometer value to correct for the drift in the gyros.

In accordance with the presently preferred compensation method of the present invention, a conventional extended Kalman filter (not shown) may also be employed in order to blend the gyro 104 measurement with the magnetometer 102 measurement, with the aforementioned difference between the magnetometer 102 and the gyro 104 being the gyro error covariance.

The above method can be employed in any magnetic heading indication system in which disturbances due to the presence of local soft iron can result in errors in magnetic heading calculations. In such an instance, by placing a gyro in the heading measurement axis and comparing the magnitude of the change in the magnetometer against the change in the gyro, any significant changes in the output of the magnetometer that is due to local magnetic field changes can be detected and corrected. Thus, the compensation method of the present invention may be employed not only in aircraft heading reference systems, such as in the integrated standby unit 200 illustrated in FIG. 2, to be described in greater detail hereinafter, but in other aircraft instruments such as primary or secondary attitude and heading reference systems, air data and attitude heading reference systems, or inertial navigation systems; as well as in non-aircraft systems such as vehicle or inertial systems that require a source of heading that may be subject to variations as a result of local electric field changes.

Referring now to FIG. 2, an example of a presently preferred integrated standby unit 200 is shown which has been enhanced and improved by implementing the previously described compensation method of the present invention. As shown and preferred in FIG. 2, the integrated standby unit 200 includes an inertial measurement unit 210 which includes triads of conventional accelerometers 212, gyros 104 and magnetometers 102, with the compensation method of the present invention being utilized with the gyros 104 and magnetometers 102 as described above. As shown and preferred, the integrated standby unit 200 may also include an integral air data measurement module 238 for conventional measurement of airspeed and altitude. The integrated standby unit 200 also preferably includes a conventional differential pressure transducer 214 and conventional absolute pressure transducer 216 fed by pitot 218 and a static port 220 as shown. In addition, the standby unit 200 also preferably includes a conventional LCD display 222, backlight 224, light sensor 226, internal temperature sensor 228, and bezel controls 230. As further shown and preferred in FIG. 2, the microprocessor 120 receives external inputs from an external configuration module 232 and a static air temperature probe 234.

Thus, the above integrated standby unit 200 illustrated in FIG. 2, comprises a series of temperature, pressure, magnetic, acceleration and rate sensors controlled by a microprocessor, such as a Freescale IMX series microprocessor, and presented on an LCD display. As such, the integrated standby system 200 provides for measurement, computation and display of flight critical information, including indicated and true airspeed, mach, static air temperature, altitude, pitch, roll, slip angle and magnetic heading. If desired, the integrated standby system 200 can be further augmented with GPS or other navigation sensors to also provide for display of course, wind and other navigational information.

In the system 200 illustrated in FIG. 2, the initial attitude and heading information is determined by means of the triaxial accelerometers 212 and magnetometers 102. At initialization, the vehicle or aircraft is assumed to be in zero acceleration state and, therefore, the combination of accelerometers 212 and magnetometers 102 provide an accurate initial state for pitch, roll and heading of the aircraft.

In the operational phase of the integrated standby unit 200, the triaxial rate sensors are preferably utilized to determine the current attitude and heading of the aircraft by monitoring and compensating for changes from the initial state. Computed angles based on rate sensor data normally suffer from a random drift, generally referred to as random walk. This drift is normally due to integration of the noise which is in the signal bandwidth and, thus, is not easily filtered by traditional signal conditioning algorithms. In order to compensate for this drift in the method of the present invention, the gyro outputs are periodically recalibrated against the magnetometer and accelerometer data. Variations of an extended Kalman filter are preferably used to periodically correct for the rate sensors drift as well as to blend all sensor data based on their corresponding error covariance. These blending and compensating algorithms provide for an accurate estimate of the aircraft attitude and heading. An example of such a blending algorithm is provided below:

$$\vec{i} = \frac{\vec{v_1}}{|\vec{v_1}|} \qquad \vec{i_D} = \frac{\vec{B_D}}{|\vec{B_D}|} \qquad \vec{i_E} = \frac{\vec{B_E}}{|\vec{B_E}|}$$

$$\vec{j} = \frac{\vec{v_1}\times\vec{v_2}}{|\vec{v_1}|} \quad \vec{j_D} = \frac{\vec{B_D}\times\vec{G_D}}{|\vec{B_D}\times\vec{G_D}|} \quad \vec{j_E} = \frac{\vec{B_E}\times\vec{G_E}}{|\vec{B_E}\times\vec{G_E}|}$$

$$\vec{k} = \vec{i}\times\vec{j} \quad \vec{k_D} = \vec{i_D}\times\vec{j_D} \quad \vec{k_E} = \vec{i_E}\times\vec{j_E}$$

$$R_{D\to I} = \begin{bmatrix} i_{Dx} & j_{Dx} & k_{Dx} \\ i_{Dy} & j_{Dy} & k_{Dy} \\ i_{Dz} & j_{Dz} & k_{Dz} \end{bmatrix}$$

$$R_{E \to I} = \begin{bmatrix} i_{Ex} & j_{Ex} & k_{Ex} \\ i_{Ey} & j_{Ey} & k_{Ey} \\ i_{Ez} & j_{Ez} & k_{Ez} \end{bmatrix}$$

$$R_{D \to E} = R_{D \to I} \cdot R_{I \to E}$$

$$\vec{v_D} \cdot R_{D \to E} = \vec{v_E}$$

A variation of the above algorithm can be used to update the attitude estimate utilizing a variation of a Kalman filter, such as illustrated below:

$$\hat{\mathbf{x}}_{k|k-1} = \mathbf{F}_k \hat{\mathbf{x}}_{k-1|k-1} + \mathbf{B}_k \mathbf{u}_k$$

$$\mathbf{P}_{k|k-1} = \mathbf{F}_k \mathbf{P}_{k-1|k-1} \mathbf{F}_k^{\mathbf{T}} + \mathbf{Q}_k$$

$$\tilde{\mathbf{y}}_k = \mathbf{z}_k - \mathbf{H}_k \hat{\mathbf{x}}_{k|k-1}$$

$$\mathbf{S}_k = \mathbf{H}_k \mathbf{P}_{k|k-1} \mathbf{H}_k^{\mathbf{T}} + \mathbf{R}_k$$

$$\mathbf{K}_k = \mathbf{P}_{k|k-1} \mathbf{H}_k^{\mathbf{T}} \mathbf{S}_k^{-1}$$

$$\hat{\mathbf{x}}_{k|k} = \hat{\mathbf{x}}_{k|k-1} + \mathbf{K}_k \tilde{\mathbf{y}}_k$$

$$\mathbf{P}_{k|k} = (I - \mathbf{K}_k \mathbf{H}_k) \mathbf{P}_{k|k-1}$$

As is well known, the local magnetic environment which surrounds the standby unit 200 in a typical aircraft panel installation is subject to variations such as magnetic effects of power switching to a nearby instrument. At install time, the standby unit 200 would preferably be calibrated in its intended environment to compensate for the effects of the local environment. However, in the course of a typical flight, various equipment is normally turned on or off which could result in an error in the magnetic heading measured by the internal magnetometers. The method of the present invention enables the system to compensate for these errors, with the algorithm $\Delta H > k$ detecting their occurrence and compensating for the resultant error above a predetermined threshold value.

It will be appreciated by one of ordinary skill in the art that numerous compensation algorithms may be used for various systems without departing from the spirit and scope of the present invention. Thus, the compensation algorithm may range from a relatively simple algorithm that periodically compares the change in the magnetic heading as measured by the magnetometers against the change in heading measured by the rate sensors, such as illustrated in FIG. 1 and represented by the previously enumerated expression:

Heading = fn(GH, MH) for $\Delta H = < k$
Heading = GH and MH=MH+ $\Delta H$ for $\Delta H > k$

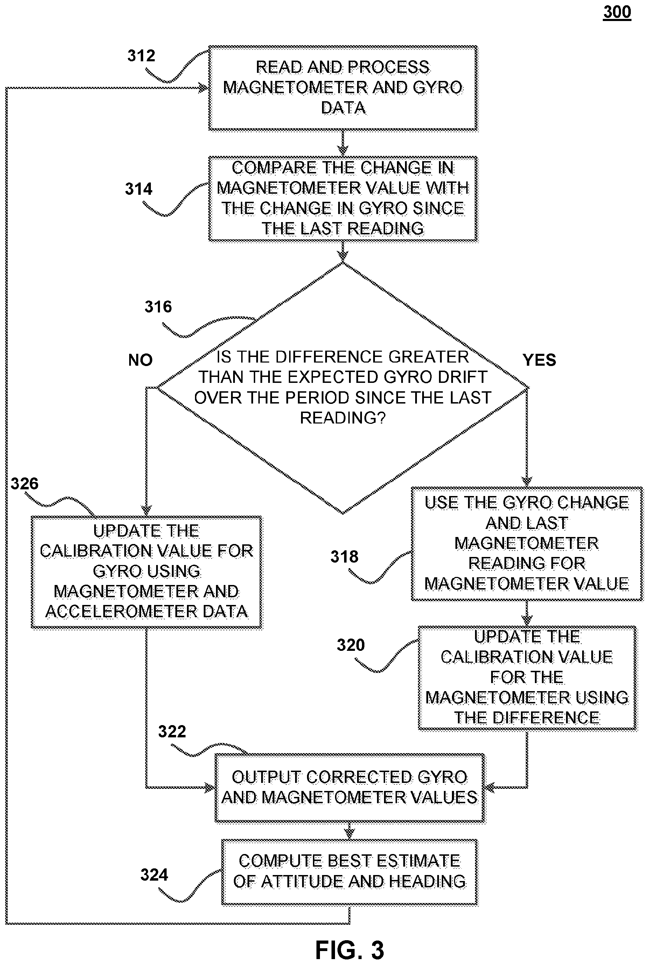

to more complex or elaborate schemes in which the rates of change of the magnetometers and rate sensors for each axis are compared, such as represented by the flow chart of FIG. 3 and the following expression:
In the case where:

XGI, YGI, ZGI represent change of angle in X, Y, Z axis as derived from gyros in inertial reference and XM, YM, ZM represent X, Y, Z
magnetometer readings and XKI, YKI, ZKI represent maximum expected gyro angular rate drift in inertial reference:

ΔX=|rate of change of XGI - rate of change of XM|
ΔY=|rate of change of YGI - rate of change of YM|
ΔZ=|rate of change of ZGI - rate of change of ZM|
Pitch = fn(YGI, Accelerometer data, Magnetometer data)
Roll = fn(XGI, Accelerometer data, Magnetometer data)
Heading = fn(ZGI, Magnetometer data)
If ΔX>XKI, XM=XM+ ΔX Δt
If ΔY>YKI, YM=YM+ ΔY Δt

Typically, in accordance with the method of the present invention, if the change is greater than the expected drift error of the rate sensors, which is a predetermined threshold value, it is assumed that the magnetometer is being affected by a local change in magnetic field and the rate sensor data is used to compensate for the effects of the change in the local magnetic field.

Referring now to FIG. 3, FIG. 3 diagrammatically illustrates an alternative flow chart, similar to FIG. 1, in accordance with a compensation method that accomplishes the above described method which utilizes the complex scheme represented by the above algorithm. It will be apparent to one of ordinary skill in the art, that the steps of the method illustrated in FIG. 3 may be performed in different orders. Like with the flow chart illustrated in FIG. 1, the flow chart of FIG. 3 is illustrated as an iterative control loop 300 for repetitively compensating for any defined significant changes in the accuracy of the heading system due to soft iron magnetic disturbances. In carrying out this compensation method, the steps may comprise saving the current value of the magnetometer readings; subtracting the current value of the magnetometer readings from the previously saved magnetometer values; dividing the difference in magnetometer readings by the time period to obtain the rate of change; subtracting the determined magnetometer rate of change from the average rate sensor change for the time period; and, if the difference is less than or equal to the maximum expected drift of the rate sensor, using the magnetometer data to compensate for the rate sensor drift. However, if that is not the case, then the rate sensor data is used to compensate for the effect of soft iron on the magnetometer.

Alternatively, as referred to above, more elaborate schemes may be utilized in which the rates of change of the magnetometers and rate sensors for each axis are compared, such as in the system 200 illustrated in FIG. 2 employing a tri-axial gyro 104, tri-axial magnetometer 102, and tri-axial accelerometer 212. In such an instance, the compensation method may comprise the steps of reading the magnetometer data for each axis; reading the gyro data for each axis; converting the gyro data from body to inertial coordinates; determining the rate of change of each magnetic axis based on the magnetometer readings over time; comparing the rate of change of each magnetic axis with the inertial coordinate rate of change of the gyro for the same axis; and, if the difference in rates of change is greater than a predetermined value, recording the difference and using it as a bias to correct for the soft iron impact on each axis of the magnetometer. However, if that is not the case, then the magnetometer values are used in the algorithm such as the Kalman filter algorithm described below which is as follows:
Predict

Predicted state estimate          $\hat{x}_{k|k-1} = F_k \hat{x}_{k-1|k-1} + B_k u_k$

Predicted estimate covariance

$$P_{k|k-1} = F_k P_{k-1|k-1} F_k^T + Q_k$$

Update

Innovation          $\tilde{y}_k = z_k - H_k \hat{x}_{k|k-1}$

Innovation covariance

$$S_k = H_k P_{k|k-1} H_k^T + R_k$$

(continued)

Optimal Kalman gain

$$\mathbf{K}_k = \mathbf{P}_{k|k-1}\mathbf{H}_k^{\mathrm{T}}\mathbf{S}_k^{-1}$$

Updated state estimate $\hat{x}_{k|k} = \hat{x}_{k|k-1} + K_k\tilde{y}_k$

Updated estimate covariance $P_{k|k} = (I - K_kH_k)P_{k|k-1}$

to correct for the drift in the gyros. Alternatively, the accelerometer data can be used in this algorithm to augment the magnetometer data during no acceleration modes such as un-accelerated straight and level motion of the vehicle or when the vehicle is stationary.

In the above situation, where the compensation method is employed in connection with each axis, such as in the system 200 of FIG. 2, in which the compensation method compares and compensates for effects of soft iron on each of the magnetometers, an internal model of the expected magnetic readings for each magnetometer is developed that estimates the expected value of each magnetometer based on estimated heading, pitch and roll of the aircraft as determined by the gyros and accelerometers. This model is periodically updated by taking into account the magnetometer readings and, as such, the change in the estimated magnetometer readings is preferably compared with the change in the actual magnetometer reading for each axis and is used to compensate for the effects of soft iron on each magnetometer or to correct the drift on each gyro.

As illustrated in FIG. 3, the steps involved in iteratively carrying out the compensation method may involve reading and processing the magnetometer 102, accelerometer 212, and gyro 104 data to provide signals corresponding to any change in magnetometer value and gyro value. This step is represented by block 312 in FIG. 3. These signals are then compared against each other to determine any actual change since the previous reading. This step is represented by block 314 in FIG. 3. A determination is then made if any detected difference in value from the previous reading is greater than the expected gyro drift over the period since the previous reading. This step is represented by block 316 in FIG. 3. If as a result of this comparison the difference exceeds the expected gyro drift, then, in accordance with the compensation method illustrated in FIG. 3, the gyro change plus the last magnetometer reading is used for the magnetometer value, represented by block 318 in FIG. 3, and the calibration value for the magnetometer is updated using the difference, represented by block 320 in FIG. 3. The corrected gyro and magnetometer values are then output, represented by block 322 in FIG. 3, and the best estimate of attitude and heading is computed, represented by block 324 in FIG. 3, and the steps are iteratively periodically repeated, as illustrated in FIG. 3. On the other hand, if the detected difference is less than the expected gyro drift over the period since the previous reading, the calibration value for the gyro is updated using the magnetometer and the accelerometer data. This step is represented by block 326 in FIG. 3, and then the corrected gyro and magnetometer values are output, as represented by block 322, the best estimate of attitude and heading is computed, represented by block 324, and the process is iteratively periodically repeated.

Referring now to FIG. 4, an embodiment of system 400 for correcting for the effects of soft iron disturbances in a dual heading and reference system installation is shown. System 400 includes two heading and reference systems such as integrated standby units 200 that are installed at different locations within the vehicle as previously illustrated and discussed in reference to FIG. 2. Each heading and reference system 200 includes triads of sensors (e.g., conventional accelerometers 212, gyros 104 and magnetometers 102) that are utilized for measuring magnetic heading and other parameters required for the navigation of a vehicle. In some embodiments, a heading and reference system can be any suitable navigation system that includes a triad of sensors such as an attitude and heading reference system, integrated standby unit, a primary and/or secondary vehicle inertial unit and/or any portable system that can be placed inside or outside a vehicle and is capable of measuring navigation parameters.

System 400 can include two or more integrated standby units 200 where each of them preferably includes a conventional differential pressure transducer 214 and conventional absolute pressure transducer 216 for conventional measurement of airspeed and altitude. In addition, standby unit 200 also preferably includes a conventional LCD display 222, backlight 224, light sensor 226, internal temperature sensor 228, and bezel controls 230. As further shown in FIG. 4, each of the integrated standby units includes microcontroller 120 that receives external inputs from an external configuration module 232 and a static air temperature probe 234.

Thus, each of the above integrated standby units 200 illustrated in FIG. 4, comprises a series of temperature, pressure, magnetic, acceleration and rate sensors controlled by a microcontroller and/or microprocessor, such as a Freescale IMX series microprocessor, and presented on an LCD display. As such, the integrated standby unit 200 provides for measurement, computation and display of flight critical information, including indicated and true airspeed, mach, static air temperature, altitude, pitch, roll, slip angle and magnetic heading. If desired, the integrated standby unit 200 can be further augmented with GPS or other navigation sensors to also provide for display of course, wind and other navigational information. Furthermore, system 400 can include any combination of heading reference units such as standby unit 200 combined with an inertial navigation unit, two inertial navigation units and/or any suitable combination thereof.

In system 400, illustrated in FIG. 4, the initial attitude and heading information is determined by means of the tri-axial accelerometers 212 and magnetometers 102 in both standby units 200. At initialization, the vehicle or aircraft is assumed to be in zero acceleration state and, therefore, the combination of accelerometers 212 and magnetometers 102 provide an accurate initial state for pitch, roll and heading of the aircraft.

In the operational phase of each of the integrated standby units 200, the tri-axial rate sensors are preferably utilized to determine the current attitude and heading of the aircraft by monitoring and compensating for changes from the initial state. Computed angles based on rate sensor data normally suffer from a random drift, generally referred to as random walk. This drift is attributed to the integration of noise which is in the signal bandwidth and, thus, is not easily filtered by traditional signal conditioning algorithms. In order to compensate for this drift the gyro outputs are periodically recalibrated against the magnetometer and accelerometer data. Variations of an extended Kalman filter are preferably used to periodically correct for the rate sensors drift as well as to blend all sensor data based on their corresponding error covariance. These blending and compensating algorithms provide for an accurate estimate of the aircraft attitude and heading and were previously discussed in reference to FIG. 2.

Furthermore, the internal magnetometers of standby units 200 also suffer from disturbances that result to unreliable measurements. Specifically, the local magnetic environment which surrounds each of the standby units 200 that are installed at different locations within the aircraft, is subject to variations such as magnetic effects of power switching to a nearby instrument and/or the presence of other, external electronic circuits that may be present in the vehicle (e.g., smartphones, computers etc.). These types of soft iron disturbances affecting the magnetometers are initially compensated for at install time, whereby each of the standby units 200 is calibrated to compensate for the effects of the local environment. Subsequently, a periodic calibration is necessary during the course of a typical flight, since various equipment is normally turned on or off which could result in an error in the magnetic heading measured by the internal magnetometers.

Moreover, it will be appreciated by one of ordinary skill in the art that with respect to the dual heading and reference system installation of system 400 numerous compensation techniques may be used for various systems without departing from the scope of the present invention. Specifically, system 400 also allows for an initial detection of the existence of localized soft iron disturbances by comparing the changes of the local magnetic field as measured by the magnetometers of the respective standby units 200. As a result, the computational and storage requirements that are associated with the periodic calculation of the navigation parameters and subsequent calibration of the sensors can be minimized by dynamically determining when to perform a calibration process that can be similar to the techniques described in FIGS. 1 and 3.

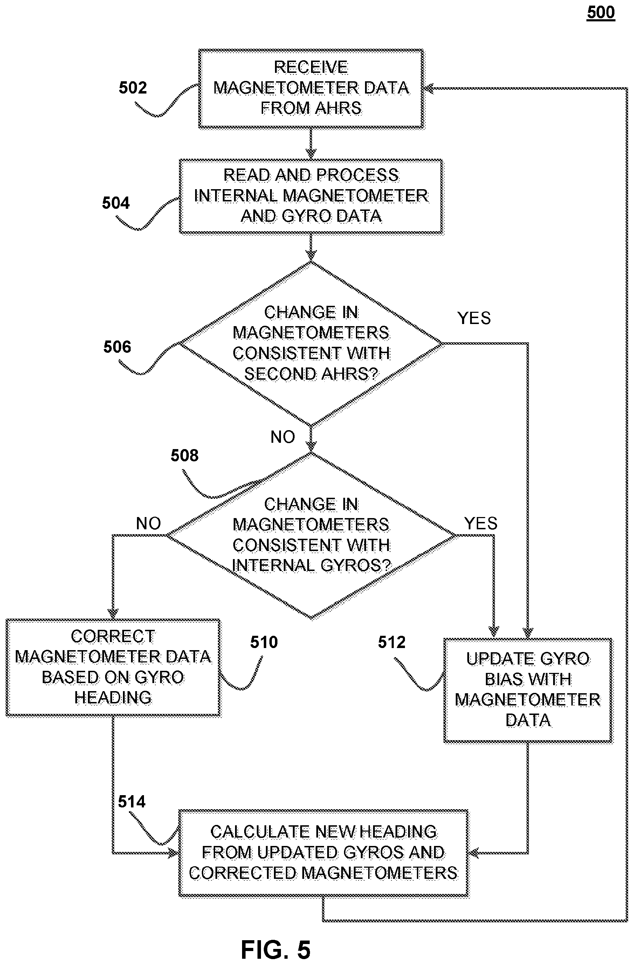

Referring now to FIG. 5, a flow chart showing method 500 for iteratively correcting for soft iron disturbances in a dual AHRS installation similar to the one referenced in FIG. 4 is provided. Specifically, at 502 one and/or both of the standby units 200 exchange the magnetometer 102, accelerometer 212, and gyro 104 sensor data as measured at the different installation locations within the vehicle. At 504, the sensor data related to internal magnetometers 102 and gyros 104 are read and processed to provide signals corresponding to any change in the magnetometer readings from the immediately previous obtained reading based on a detection period $\Delta t$.

The magnetometer change signal obtained from each of the standby units 200 reflects any deviation of the intensity and direction of the magnetic field as measured by the internal magnetometers during the detection period. At 506 a determination is made to ascertain if the magnetometer change signals from each of the standby units 200 are consistent with each other. This can be accomplished by computing a difference of the change signals and if that difference does not exceed a pre-determined threshold (e.g., "YES" at 506) then no indication of local soft iron magnetic disturbances has been detected in the internal magnetometers of each of standby units 200. As a result, at 512, the internal magnetometers of standby units 200 can be used to correct the gyro measurements by updating the gyro drift and subsequently calibrating the gyro sensors using the updated gyro drift. For example, such calibration can be accomplished by using the magnetometer readings to provide a heading value that can be used to update the gyro drift during the detection period and subsequently be subtracted by the gyro measurements. Thus, a new heading can be calculated at 514 using the calibrated gyro measurements and the magnetometers.

Moreover, detecting an indication of soft iron magnetic disturbances in two or more installations of heading and reference systems may be represented by the following algorithm:

$th$ is an acceptable positive constant derived from expected magnetic values of the local magnetic field;
$\Delta M_1$ is the change in the magnetometer reading associated with the first heading and reference system during detection period $\Delta t$;
$\Delta M_2$ is the change in the magnetometer reading associated with the second heading and reference system during detection period $\Delta t$;
An indication of soft iron disturbances is detected if $|\Delta M_1 - \Delta M_2| > th$.

In some embodiments, the acceptable threshold may be determined using theoretical magnetic field values obtained from a model of the Earth's magnetic field. For example, such information can be obtained from a website or any other suitable source and/or database that provides information relating to the Earth's magnetic field. In some embodiments, the theoretical magnetic field values can be stored in a memory element included in microprocessor 120 of standby unit 200 and accessed during the detection period in order to identify and perform the compensation techniques described herein.

If, however, the difference of the magnetometer change signals from each of the standby units 200 does exceed a pre-defined threshold, indicating that the change of measurements of the internal magnetometers among the two heading and reference systems is not consistent (e.g., "NO" at 506) then a subsequent determination is needed at 508 to detect the heading and reference system that is possibly exposed to soft iron magnetic disturbances and identify its location within the vehicle. Such a determination is accomplished by computing for each standby unit 200 a pair of expected heading values using their respective internal magnetometers and the gyros and computing a difference (e.g., a change signal) between the expected heading as measured by the magnetometers and the gyros for each standby unit 200. If the difference does not exceed a pre-defined threshold, thus indicating that the change in the expected heading as measured by the magnetometers and gyros is consistent (e.g., "YES" at 508) across standby units 200 then method 500 proceeds to 512 and uses the internal magnetometers of standby units 200 to correct the gyro measurements by updating the gyro drift and subsequently calibrating the gyro sensors using the updated gyro drift. A new heading can be then calculated at 514 using the calibrated gyro measurements and the magnetometers.

If, however, the difference does exceed a pre-defined threshold, thus indicating that the change in the expected heading as measured by the magnetometers and gyros is not consistent across standby units 200 (e.g., "YES" at 508), then the standby unit exhibiting the largest deviation from the pre-defined threshold is identified as being susceptible to soft iron disturbances thereby requiring calibration of the magnetometers. This can be accomplished at 510 by calibrating the magnetometer data using the heading measurement obtained by the gyroscopes. In some embodiments, a magnetometer calibration value can be computed using the difference of an immediately previous heading measurement obtained from the magnetometers and the current heading as computed from the gyros. In some embodiments, the computed gyro heading can be obtained from either of the standby units and/or as a combination (e.g., average) from both standby units 200.

In some embodiments, a conventional extended Kalman filter as discussed above in reference with FIG. 2 may also be employed in order to blend the gyro 104 measurements with the magnetometer 102 measurements, with the aforementioned difference between the magnetometers 102 and the gyros 104 that is computed at 508 being dependent on the gyro error covariance.

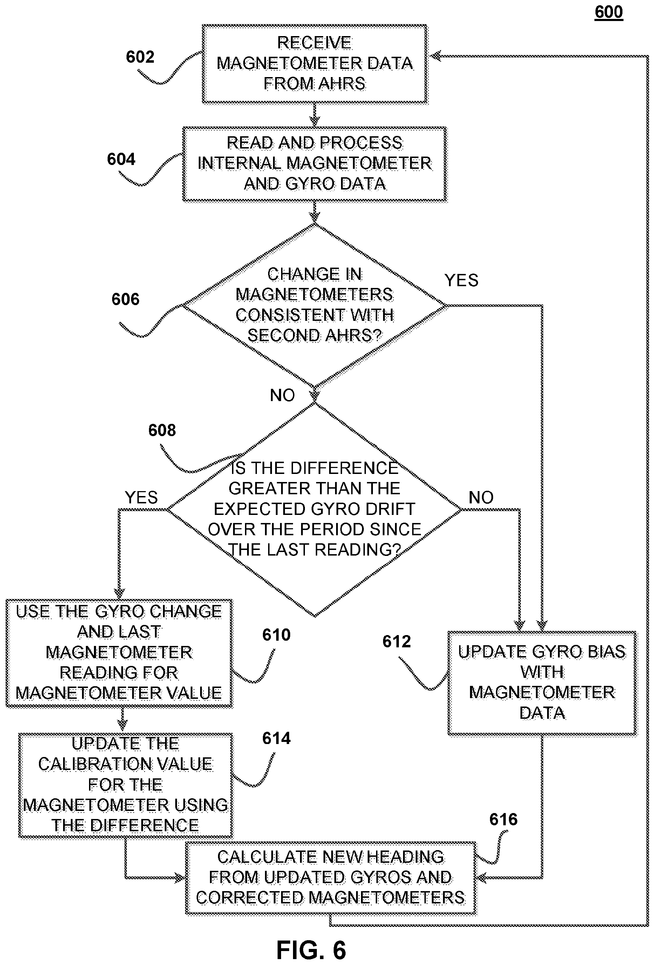

FIG. 6 illustrates a flow chart of method 600 for iteratively correcting for soft iron disturbances in magnetometers in a dual heading and reference system installation, as illustrated in FIG. 4, using data associated with the expected gyro drift as previously discussed in reference to FIGS. 1 and 5. Specifically, at 602 one and/or more of standby units 200 exchange/receive the magnetometer 102, accelerometer 212, and gyro 104 sensor data as measured at the different installation locations within the vehicle. At 604, the sensor data related to internal magnetometers 102 and gyros 104 are read and processed to provide signals corresponding to any change in the magnetometer readings from the immediately previous obtained reading during a detection period Δt. The magnetometer readings provide the intensity and direction of the magnetic field and their computed difference during the detection period reflects any deviation of the local magnetic field.

At 606 a determination is made to ascertain whether the magnetometer change signals derived from the two standby units 200 are consistent by computing, for example, a difference of the change signals and if that difference does not exceed a pre-determined threshold (e.g., "YES" at 606) then no local soft iron magnetic disturbances have been detected in the internal magnetometers of each of the standby units 200. As a result, at 612, the internal magnetometers of standby units 200 can be used to correct the gyro measurements by updating the gyro drift and subsequently calibrating the gyro sensors using the updated gyro drift. In some embodiments, such calibration can be accomplished by using the magnetometer readings to provide a heading value that can be used to update the gyro drift during the detection period and subsequently be subtracted from the gyro measurements. Thus, a new heading can be calculated at 616 using the calibrated gyro measurements and the magnetometers.

If, however, the difference of the magnetometer change signals from each of the standby units 200 does exceed a pre-defined threshold, indicating that the change of measurements of the internal magnetometers among the two heading and reference systems is not consistent (e.g., "NO" at 606) then a subsequent determination is needed at 608 to detect the level of deviation that can be attributed to soft iron magnetic disturbances for one or both of the heading and reference systems. Such a determination is accomplished by detecting whether the difference in value from the previous reading exceeds a pre-determined acceptable threshold value that is defined as the expected gyro drift over the period since the last reading for each standby unit 200. If the difference does not exceed the expected gyro drift during the detection period (e.g., "YES" at 608) across standby units 200 then method 600 proceeds to 612 and uses the internal magnetometers of standby units 200 to correct the gyro measurements by updating the gyro drift and subsequently calibrating the gyro sensors using the updated gyro drift. A new heading can be then calculated at 614 using the calibrated gyro measurements and the magnetometers.

If, however, the difference does exceed the expected gyro drift for one or both standby units 200 (e.g., "YES" at 608), then the standby unit exhibiting the largest deviation from the expected gyro drift is identified as being susceptible to soft iron disturbances thereby requiring calibration of the magnetometers. In some embodiments, both standby units 200 may be considered as being affected from soft iron disturbances, thus requiring calibration that can be achieved either in parallel (e.g., simultaneous calibration) and/or sequentially. This can be accomplished at 610 by using the gyro change plus the last magnetometer reading for the magnetometer value and updating, at 614, the calibration value for the magnetometer using the difference. The corrected gyro and magnetometer values are then used to calculate the best estimate of attitude and heading, as shown at 616, and the steps are iteratively periodically repeated. Such compensation techniques can range from simple to complex as were previously discussed in reference to FIGS. 1-2.

In some embodiments, a conventional extended Kalman filter as discussed above in reference with FIG. 2 may also be employed in order to blend the gyro 104 measurements with the magnetometer 102 measurements, with the aforementioned difference between the magnetometers 102 and the gyros 104 that is computed at 508 being dependent on the gyro error covariance.

While there have been shown and described various novel features of the invention as applied to particular embodiments thereof, it should be understood that various omissions and substitutions and changes in the form and details of the systems and methods described and illustrated may be made by those skilled in the art without departing from the scope of the appended claims. Those skilled in the art will recognize, based on the above disclosure and an understanding therefrom of the teachings of the invention, that the general structure and functionality provided by and incorporated therein, may vary in different embodiments of the invention. Accordingly, the particular systems and methods shown in FIG. 1 - FIG. 6 are for illustrative purposes to facilitate a full and complete understanding and appreciation of the various aspects and functionality of particular embodiments of the invention as realized in system and method embodiments thereof. Those skilled in the art will appreciate that the invention can be practiced in other than the described embodiments, which are presented for purposes of illustration and not limitation, and the present invention is limited only by the claims which follow.

**Claims**

1. A system for compensating for soft iron magnetic disturbances in a heading reference system (100, 200) of a vehicle, the system comprising:

   a first magnetometer (102);
   a second magnetometer (102) located at a different location on the vehicle from the first magnetometer (102);
   a first heading gyro (104) coupled to the first magnetometer (102);
   a second heading gyro (104) coupled to the second magnetometer (102); and
   a processor (120) configured to:

   receive magnetometer data from the first magnetometer (102);
   receive magnetometer data from the second magnetometer (102);
   determine whether one of the first or second magnetometers (102) is potentially soft iron disturbed using: (a) the magnetometer data received from the first and second magnetometers (102) to provide first and second change signals corresponding to changes in the first and second magnetometer readings from a previously obtained reading during a detection period and (b) a pre-determined threshold that is used to determine whether the first change signal for the first magnetometer (102) is consistent with the second change signal for the second magnetometer (102);
   in response to determining that one of the first or second magnetometers (102) is potentially soft iron disturbed, determine which of the first or second magnetometers (102) is potentially soft iron disturbed using: a first threshold based on an expected drift of the first heading gyro over the detection period (104), and a second threshold based on an expected drift of the second heading gyro over the detection period (104), wherein the determination of which of the first or second magnetometers (102) is potentially soft iron disturbed is accomplished by detecting whether the first or second change signal exceeds the first or second threshold; and
   compensate for soft iron magnetic disturbance by taking into account measurements of the first heading gyro (104), the second heading gyro (104), the first magnetometer (102), and the second magnetometer (102), and provide a corrected heading.

**2.** The system of claim 1, wherein in order to determine whether one of the first or second magnetometers (102) is potentially soft iron disturbed, the processor (120) is configured to:

generate a first value and a second value indicating a change of a magnetic field during a detection period based on data received from the first magnetometer (102) and the second magnetometer (102), respectively; determine a difference of change of the magnetic field between the first value based on the first magnetometer (102) and the second value based on the second magnetometer (102); and determine that a magnitude of the difference of change of the magnetic field exceeds the pre-determined threshold.

**3.** The system of claim 1, wherein in response to determining that neither of the first or second magnetometers (102) is potentially soft iron disturbed, the processor (120) is configured to:

use magnetometer data received from the first magnetometer (102) to provide a first heading value to calibrate the first heading gyro (104); and use magnetometer data received from the second magnetometer (102) to provide a second heading value to calibrate the second heading gyro (104).

**4.** The system of claim 1, wherein:

in response to determining that the first change signal exceeds the first threshold, the processor (120) is configured to use a gyro reading from the first heading gyro (104) to calibrate the first magnetometer (102); and in response to determining that the second change signal exceeds the second threshold, the processor (120) is configured to use a gyro reading from the second heading gyro (104) to calibrate the second magnetometer (102).

**5.** The system of claim 1, wherein

in response to determining that the first change signal does not exceed the first threshold, the processor (120) is configured to use magnetometer data received from the first magnetometer (102) to provide a first heading value to calibrate the first heading gyro (104); and in response to determining that the second change signal does not exceed the second threshold, the processor (120) is configured to use magnetometer data received from the second magnetometer (102) to provide a second heading value to calibrate the second heading gyro (104).

**6.** The system of claim 1, wherein the first magnetometer (102) and the second magnetometer (102) are tri-axial magnetometers and the first heading gyro (104) and the second heading gyro (104) are tri-axial gyroscopes.

**7.** The system of claim 1, wherein the heading reference system (100, 200) is an aircraft heading reference system, or an integrated standby unit, or an attitude and heading reference system, or an inertial navigation system.

**8.** The system of claim 1, wherein the first magnetometer (102) and the first heading gyro (104) are included in a first heading reference system (100, 200) and the second magnetometer (102) and second heading gyro (104) are included in a second heading reference system (100, 200).

**9.** A method for compensating for soft iron magnetic disturbances in a heading reference system (100, 200) of a vehicle, the method comprising:

receiving magnetometer data from a first magnetometer (102); receiving magnetometer data from a second magnetometer (102), wherein the second magnetometer (102) is at a different location on the vehicle from the first magnetometer (102); determining whether one of the first or second magnetometers (102) is potentially soft iron disturbed using: (a) the magnetometer data received from the first and second magnetometers (102) to provide first and second change signals corresponding to changes in the first and second magnetometer readings from a previously obtained reading during a detection period and (b) a pre-determined threshold that is used to determine whether the first change signal for the first magnetometer (102) is consistent with the second change signal for the second magnetometer (102); in response to determining that one of the first or second magnetometers (102) is potentially soft iron disturbed, determining which of the first or second magnetometers (102) is potentially soft iron disturbed by using: a first threshold based on an expected drift of a first heading gyro (104) associated with the first magnetometer (102), and a second threshold based on an expected drift of a second heading gyro (104) associated with the second magnetometer (102), wherein the determination of which of the first or second magnetometers (102) is potentially soft iron disturbed is accomplished by detecting whether the first change signal or second change signal exceeds the first or second threshold; and

compensating for soft iron magnetic disturbance by taking into account measurements of the first heading gyro (104), the second heading gyro (104), the first magnetometer (102), and the second magnetometer (102), and providing a corrected heading.

10. The method of claim 9, wherein determining whether one of the first or second magnetometers (102) is potentially soft iron disturbed further comprises:

generating a first value and a second value indicating a change of a magnetic field during a detection period based on data received from the first magnetometer (102) and the second magnetometer (102), respectively; determining a difference of change of the magnetic field between the first value based on the first magnetometer (102) and the second value based on the second magnetometer (102); and determining that a magnitude of the difference of change of the magnetic field exceeds the pre-determined threshold.

11. The method of claim 9 further comprising:

in response to determining that neither of the first or second magnetometers (102) is potentially soft iron disturbed, using magnetometer data received from the first magnetometer (102) to provide a first heading value to calibrate the first heading gyro (104) associated with the first magnetometer (102); and using magnetometer data received from the second magnetometer (102) to provide a second heading value to calibrate the second heading gyro (104) associated with the second magnetometer (102).

12. The method of claim 9 further comprising:

in response to determining that the first change signal exceeds the first threshold, using a gyro reading from the first heading gyro (104) to calibrate the first magnetometer (102) associated with the first heading gyro (104); and in response to determining that the second change signal exceeds the second threshold, using a gyro reading from the second heading gyro (104) to calibrate the second magnetometer (102) associated with the second heading gyro (104).

13. The method of claim 9 further comprising:

in response to determining that the first change signal does not exceed the first threshold, using magnetometer data received from the first magnetometer (102) to provide a first heading value to calibrate the first heading gyro (104) associated with the first magnetometer (102); and in response to determining that the second change signal does not exceed the second threshold, using magnetometer data received from the second magnetometer (102) to provide a second heading value to calibrate the second heading gyro (104) associated with the second magnetometer (102).

**Patentansprüche**

1. System zum Kompensieren von Weicheisen-Magnetstörungen in einem Kursreferenzsystem (100, 200) eines Fahrzeugs, wobei das System Folgendes umfasst:

ein erstes Magnetometer (102); ein zweites Magnetometer (102), das an einer anderen Position auf dem Fahrzeug als das erste Magnetometer (102) angeordnet ist; einen ersten Kurskreisel (104), der mit dem ersten Magnetometer (102) gekoppelt ist; einen zweiten Kurskreisel (104), der mit dem zweiten Magnetometer (102) gekoppelt ist; und einen Prozessor (120), der ausgelegt ist, um:

Magnetometerdaten von dem ersten Magnetometer (102) zu empfangen;

Magnetometerdaten von dem zweiten Magnetometer (102) zu empfangen;

zu bestimmen, ob eines aus dem ersten und dem zweiten Magnetometer (102) möglicherweise durch Weicheisen gestört ist, unter Verwendung von: (a) den von dem ersten und dem zweiten Magnetometer (102) empfangenen Magnetometerdaten zum Bereitstellen von einem ersten und einem zweiten Änderungssignal, die Änderungen der Auslesungen des ersten und des zweiten Magnetometers von einer zuvor erhaltenen Auslesung während einer Detektionszeitspanne entsprechen, und (b) eines vorbestimmten Schwellenwerts, der verwendet wird, um zu bestimmen, ob das erste Änderungssignal für das erste Magnetometer (102) mit dem zweiten Änderungssignal für das zweite Magnetometer (102) übereinstimmt;

als Reaktion auf das Bestimmen, dass eines aus dem ersten und dem zweiten Magnetometer (102) möglicherweise durch Weicheisen gestört ist, zu bestimmen, welches aus dem ersten und dem zweiten Magnetometer (102) möglicherweise durch Weicheisen gestört ist, unter Verwendung von: einem ersten Schwellenwert, basierend auf einer erwarteten Drift des ersten Kurskreisels während der Detektionszeitspanne (104), und einem zweiten Schwellenwert, basierend auf einer erwarteten Drift des zweiten Kurskreisels während der Detektionszeitspanne (104), wobei die Bestimmung, welches aus dem ersten und dem zweiten Magnetometer (102) möglicherweise durch Weicheisen gestört ist, durch Detektieren erreicht wird, ob das erste oder das zweite Änderungssignal den ersten oder den zweiten Schwellenwert überschreitet; und

durch Berücksichtigen von Messungen des ersten Kurskreisels (104), des zweiten Kurskreisels (104), des ersten Magnetometers (102) und des zweiten Magnetometers (102) für Weicheisen-Magnetstörungen zu kompensieren und einen korrigierten Kurs bereitzustellen.

2. System nach Anspruch 1, wobei um zu bestimmen, welches aus dem ersten und dem zweiten Magnetometer (102) möglicherweise durch Weicheisen gestört ist, der Prozessor (120) ausgelegt ist, um:

einen ersten Wert und einen zweiten Wert zu erzeugen, die eine Änderung eines Magnetfelds während einer Detektionszeitspanne basierend auf Daten angeben, die von dem ersten Magnetometer (102) bzw. dem zweiten Magnetometer (102) empfangen wurden;

eine Differenz der Änderung des Magnetfelds zwischen dem ersten Wert, basierend auf dem ersten Magnetometer (102), und dem zweiten Wert, basierend auf dem zweiten Magnetometer (102), zu bestimmen; und

zu bestimmen, dass eine Größenordnung der Differenz der Änderung des Magnetfelds den vorbestimmten Schwellenwert überschreitet.

3. System nach Anspruch 1, wobei der Prozessor (120) als Reaktion auf das Bestimmen, dass weder das erste noch das zweite Magnetometer (102) möglicherweise durch Weicheisen gestört ist, ausgelegt ist, um:

Magnetometerdaten, die von dem ersten Magnetometer (102) empfangen wurden, zu verwenden, um einen ersten Kurswert bereitzustellen, um den ersten Kurskreisel (104) zu kalibrieren; und

Magnetometerdaten, die von dem zweiten Magnetometer (102) empfangen wurden, zu verwenden, um einen zweiten Kurswert bereitzustellen, um den zweiten Kurskreisel (104) zu kalibrieren.

4. System nach Anspruch 1, wobei:

der Prozessor (120) als Reaktion auf das Bestimmen, dass das erste Änderungssignal den ersten Schwellenwert überschreitet, ausgelegt ist, eine Kreiselauslesung von dem ersten Kurskreisel (104) zu verwenden, um das erste Magnetometer (102) zu kalibrieren; und

der Prozessor (120) als Reaktion auf das Bestimmen, dass das zweite Änderungssignal den zweiten Schwellenwert überschreitet, ausgelegt ist, eine Kreiselauslesung von dem zweiten Kurskreisel (104) zu verwenden, um das zweite Magnetometer (102) zu kalibrieren.

5. System nach Anspruch 1, wobei:

der Prozessor (120) als Reaktion auf das Bestimmen, dass das erste Änderungssignal den ersten Schwellenwert nicht überschreitet, ausgelegt ist, um Magnetometerdaten, die von dem ersten Magnetometer (102) empfangen wurden, zu verwenden, um einen ersten Kurswert bereitzustellen, um den ersten Kurskreisel (104) zu kalibrieren; und

der Prozessor (120) als Reaktion auf das Bestimmen, dass das zweite Änderungssignal den zweiten Schwellenwert nicht überschreitet, ausgelegt ist, um Magnetometerdaten, die von dem zweiten Magnetometer (102) empfangen wurden, zu verwenden, um einen zweiten Kurswert bereitzustellen, um den zweiten Kurskreisel (104) zu kalibrieren.

**6.** System nach Anspruch 1, wobei das erste Magnetometer (102) und das zweite Magnetometer (102) triaxiale Magnetometer sind, und der erste Kurskreisel (104) und der zweite Kurskreisel (104) triaxiale Kreisel sind.

**7.** System nach Anspruch 1, wobei das Kursreferenzsystem (100, 200) ein Flugzeugkursreferenzsystem oder eine integrierte Standby-Einheit oder ein Fluglage- und Kursreferenzsystem oder ein inertes Navigationssystem ist.

**8.** System nach Anspruch 1, wobei das erste Magnetometer (102) und der erste Kurskreisel (104) in einem ersten Kursreferenzsystem (100, 200) enthalten sind, und das zweite Magnetometer (102) und der zweite Kurskreisel (104) in einem zweiten Kursreferenzsystem (100, 200) enthalten sind.

**9.** Verfahren zum Kompensieren für Weicheisen-Magnetstörungen in einem Kursreferenzsystem (100, 200) eines Fahrzeugs, wobei das Verfahren Folgendes umfasst:

Empfangen von Magnetometerdaten von einem ersten Magnetometer (102);
Empfangen von Magnetometerdaten von einem zweiten Magnetometer (102), wobei das zweite Magnetometer (102) an einer anderen Position auf dem Fahrzeug als das erste Magnetometer (102) angeordnet ist;
Bestimmen, ob eines aus dem ersten und dem zweiten Magnetometer (102) möglicherweise durch Weicheisen gestört ist, unter Verwendung von: (a) den von dem ersten und dem zweiten Magnetometer (102) empfangenen Magnetometerdaten zum Bereitstellen von einem ersten und einem zweiten Änderungssignal, die Änderungen der Auslesungen des ersten und des zweiten Magnetometers von einer zuvor erhaltenen Auslesung während einer Detektionszeitspanne entsprechen, und (b) eines vorbestimmten Schwellenwerts, der verwendet wird, um zu bestimmen, ob das erste Änderungssignal für das erste Magnetometer (102) mit dem zweiten Änderungssignal für das zweite Magnetometer (102) übereinstimmt;
als Reaktion auf das Bestimmen, dass eines aus dem ersten und dem zweiten Magnetometer (102) möglicherweise durch Weicheisen gestört ist, Bestimmen, welches aus dem ersten und dem zweiten Magnetometer (102) möglicherweise durch Weicheisen gestört ist, unter Verwendung von: einem ersten Schwellenwert, basierend auf einer erwarteten Drift eines ersten Kurskreisels, der dem ersten Magnetometer zugeordnet ist, und einem zweiten Schwellenwert, basierend auf einer erwarteten Drift eines zweiten Kurskreisels (104), der dem zweiten Magnetometer zugeordnet ist, wobei die Bestimmung, welches aus dem ersten und dem zweiten Magnetometer (102) möglicherweise durch Weicheisen gestört ist, durch Detektieren erreicht wird, ob das erste oder das zweite Änderungssignal den ersten oder den zweiten Schwellenwert überschreitet; und
Kompensieren für Weicheisen-Magnetstörungen durch Berücksichtigen von Messungen des ersten Kurskreisels (104), des zweiten Kurskreisels (104), des ersten Magnetometers (102) und des zweiten Magnetometers (102) und Bereitstellen eines korrekten Kurses.

**10.** Verfahren nach Anspruch 9, wobei das Bestimmen, ob eines aus dem ersten und dem zweiten Magnetometer (102) möglicherweise durch Weicheisen gestört ist, ferner Folgendes umfasst:

Erzeugen eines ersten Werts und eines zweiten Werts, die eine Änderung eines Magnetfelds während einer Detektionszeitspanne basierend auf Daten angeben, die von dem ersten Magnetometer (102) bzw. dem zweiten Magnetometer (102) empfangen wurden;
Bestimmen einer Differenz der Änderung des Magnetfelds zwischen dem ersten Wert, basierend auf dem ersten Magnetometer (102), und dem zweiten Wert, basierend auf dem zweiten Magnetometer (102); und
Bestimmen, dass eine Größenordnung der Differenz der Änderung des Magnetfelds den vorbestimmten Schwellenwert überschreitet.

**11.** Verfahren nach Anspruch 9, das ferner Folgendes umfasst:
als Reaktion auf das Bestimmen, dass weder das erste noch das zweite Magnetometer (102) möglicherweise durch Weicheisen gestört ist:

Verwenden von Magnetometerdaten, die von dem ersten Magnetometer (102) empfangen wurden, um einen ersten Kurswert bereitzustellen, um den ersten Kurskreisel (104) zu kalibrieren, der dem ersten Magnetometer (102) zugeordnet ist; und
Verwenden von Magnetometerdaten, die von dem zweiten Magnetometer (102) empfangen wurden, um einen zweiten Kurswert bereitzustellen, um den zweiten Kurskreisel (104) zu kalibrieren, der dem zweiten Magnetometer (102) zugeordnet ist.

**12.** Verfahren nach Anspruch 9, das ferner Folgendes umfasst:

als Reaktion auf das Bestimmen, dass das erste Änderungssignal den ersten Schwellenwert überschreitet, Verwenden einer Kreiselauslesung von dem ersten Kurskreisel (104), um das erste Magnetometer (102) zu kalibrieren, das dem ersten Kurskreisel (104) zugeordnet ist; und

als Reaktion auf das Bestimmen, dass das zweite Änderungssignal den zweiten Schwellenwert überschreitet, Verwenden einer Kreiselauslesung von dem zweiten Kurskreisel (104), um das zweite Magnetometer (102) zu kalibrieren, das dem zweiten Kurskreisel (104) zugeordnet ist.

**13.** Verfahren nach Anspruch 9, das ferner Folgendes umfasst:

als Reaktion auf das Bestimmen, dass das erste Änderungssignal den ersten Schwellenwert nicht überschreitet, Verwenden von Magnetometerdaten, die von dem ersten Magnetometer (102) empfangen wurden, um einen ersten Kurswert bereitzustellen, um den ersten Kurskreisel (104) zu kalibrieren, der dem ersten Magnetometer (102) zugeordnet ist; und

als Reaktion auf das Bestimmen, dass das zweite Änderungssignal den zweiten Schwellenwert nicht überschreitet, Verwenden von Magnetometerdaten, die von dem zweiten Magnetometer (102) empfangen wurden, um einen zweiten Kurswert bereitzustellen, um den zweiten Kurskreisel (104) zu kalibrieren, der dem zweiten Magnetometer (102) zugeordnet ist.

## Revendications

**1.** Système permettant de compenser les perturbations magnétiques de fer doux dans un système de référence de cap (100, 200) d'un véhicule, le système comprenant :

un premier magnétomètre (102) ;
un deuxième magnétomètre (102) situé à un emplacement, sur le véhicule, qui est différent de l'emplacement du premier magnétomètre (102) ;
un premier gyroscope de cap (104) couplé au premier magnétomètre (102) ;
un deuxième gyroscope de cap (104) couplé au deuxième magnétomètre (102) ; et
un processeur (120) configuré de manière à :

recevoir des données magnétométriques en provenance du premier magnétomètre (102) ;
recevoir des données magnétométriques en provenance du deuxième magnétomètre (102) ;
déterminer si l'un du premier ou deuxième magnétomètre (102) est potentiellement perturbé par du fer doux en utilisant : (a) les données magnétométriques reçues en provenance des premier et deuxième magnétomètres (102) pour fournir des premier et deuxième signaux de changement correspondant à des changements dans les lectures des premier et deuxième magnétomètres par rapport à une lecture précédemment obtenue pendant une période de détection, et (b) un seuil prédéterminé qui est utilisé pour déterminer si le premier signal de changement pour le premier magnétomètre (102) est cohérent avec le deuxième signal de changement pour le deuxième magnétomètre (102) ;
en réponse à une détermination selon laquelle l'un du premier ou deuxième magnétomètre (102) est potentiellement perturbé par du fer doux, déterminer lequel du premier ou deuxième magnétomètre (102) est potentiellement perturbé par du fer doux en utilisant : un premier seuil basé sur une dérive attendue du premier gyroscope de cap sur la période de détection (104), et un deuxième seuil basé sur une dérive attendue du deuxième gyroscope de cap sur la période de détection (104), dans laquelle l'étape consistant à déterminer lequel du premier ou du deuxième magnétomètre (102) est potentiellement perturbé par du fer doux est réalisée en détectant si le premier ou le deuxième signal de changement dépasse le premier ou le deuxième seuil ; et
compenser les perturbations magnétiques de fer doux en tenant compte des mesures du premier gyroscope de cap (104), du deuxième gyroscope de cap (104), du premier magnétomètre (102) et du deuxième magnétomètre (102), et fournir un cap corrigé.

**2.** Système selon la revendication 1, dans lequel, afin de déterminer si l'un du premier ou deuxième magnétomètre (102) est potentiellement perturbé par du fer doux, le processeur (120) est configuré de manière à :

générer une première valeur et une deuxième valeur indiquant un changement d'un champ magnétique pendant une période de détection, sur la base des données reçues en provenance du premier magnétomètre (102) et du deuxième magnétomètre (102), respectivement ;
déterminer une différence de changement du champ magnétique entre la première valeur basée sur le premier magnétomètre (102) et la deuxième valeur basée sur le deuxième magnétomètre (102) ; et
déterminer qu'une grandeur de la différence de changement du champ magnétique dépasse le seuil prédéterminé.

3. Système selon la revendication 1, dans lequel, en réponse à une détermination selon laquelle ni le premier ni le deuxième magnétomètre (102) n'est potentiellement perturbé par du fer doux, le processeur (120) est configuré de manière à :

utiliser des données magnétométriques reçues en provenance du premier magnétomètre (102) pour fournir une première valeur de cap afin de calibrer le premier gyroscope de cap (104) ; et
utiliser des données magnétométriques reçues en provenance du deuxième magnétomètre (102) pour fournir une deuxième valeur de cap afin de calibrer le deuxième gyroscope de cap (104).

4. Système selon la revendication 1, dans lequel :

en réponse à une détermination selon laquelle le premier signal de changement dépasse le premier seuil, le processeur (120) est configuré de manière à utiliser une lecture gyroscopique du premier gyroscope de cap (104) pour calibrer le premier magnétomètre (102) ; et
en réponse à une détermination selon laquelle le deuxième signal de changement dépasse le deuxième seuil, le processeur (120) est configuré de manière à utiliser une lecture gyroscopique du deuxième gyroscope de cap (104) pour calibrer le deuxième magnétomètre (102).

5. Système selon la revendication 1, dans lequel

en réponse à une détermination selon laquelle le premier signal de changement ne dépasse pas le premier seuil, le processeur (120) est configuré de manière à utiliser les données magnétométriques reçues en provenance du premier magnétomètre (102) pour fournir une première valeur de cap permettant de calibrer le premier gyroscope de cap (104) ; et
en réponse à une détermination selon laquelle le deuxième signal de changement ne dépasse pas le deuxième seuil, le processeur (120) est configuré de manière à utiliser les données magnétométriques reçues en provenance du deuxième magnétomètre (102) pour fournir une deuxième valeur de cap permettant de calibrer le deuxième gyroscope de cap (104).

6. Système selon la revendication 1, dans lequel le premier magnétomètre (102) et le deuxième magnétomètre (102) sont des magnétomètres triaxiaux et le premier gyroscope de cap (104) et le deuxième gyroscope de cap (104) sont des gyroscopes triaxiaux.

7. Système selon la revendication 1, dans lequel le système de référence de cap (100, 200) est un système de référence de cap d'aéronef, ou une unité de veille intégrée, ou un système de référence d'attitude et de cap, ou un système de navigation inertielle.

8. Système selon la revendication 1, dans lequel le premier magnétomètre (102) et le premier gyroscope de cap (104) sont inclus dans un premier système de référence de cap (100, 200) et le deuxième magnétomètre (102) et le deuxième gyroscope de cap (104) sont inclus dans un deuxième système de référence de cap (100, 200).

9. Procédé permettant de compenser des perturbations magnétiques de fer doux dans un système de référence de cap (100, 200) d'un véhicule, le procédé comprenant les étapes ci-dessous consistant à :

recevoir des données magnétométriques en provenance d'un premier magnétomètre (102) ;
recevoir des données magnétométriques en provenance d'un deuxième magnétomètre (102), dans lequel le deuxième magnétomètre (102) est situé à un emplacement, sur le véhicule, qui est différent de l'emplacement du premier magnétomètre (102) ;
déterminer si l'un du premier ou deuxième magnétomètre (102) est potentiellement perturbé par du fer doux, en utilisant : (a) les données magnétométriques reçues en provenance des premier et deuxième magnétomètres (102) pour fournir des premier et deuxième signaux de changement correspondant à des changements dans les lectures des premier et deuxième magnétomètres par rapport à une lecture précédemment obtenue pendant une période de détection, et (b) un seuil prédéterminé qui est utilisé pour déterminer si le premier signal de changement pour le premier magnétomètre (102) est cohérent avec le deuxième signal de changement pour le deuxième magnétomètre (102) ;

en réponse à une détermination selon laquelle l'un du premier ou deuxième magnétomètre (102) est potentiellement perturbé par du fer doux, déterminer lequel du premier ou deuxième magnétomètre (102) est potentiellement perturbé par du fer doux, en utilisant : un premier seuil basé sur une dérive attendue d'un premier gyroscope de cap (104) associé au premier magnétomètre (102), et un deuxième seuil basé sur une dérive attendue d'un deuxième gyroscope de cap (104) associé au deuxième magnétomètre (102), dans laquelle l'étape consistant à déterminer lequel du premier ou du deuxième magnétomètre (102) est potentiellement perturbé par du fer doux est réalisée en détectant si le premier ou le deuxième signal de changement dépasse le premier ou le deuxième seuil ; et

compenser les perturbations magnétiques de fer doux en tenant compte des mesures du premier gyroscope de cap (104), du deuxième gyroscope de cap (104), du premier magnétomètre (102) et du deuxième magnétomètre (102), et fournir un cap corrigé.

**10.** Procédé selon la revendication 9, dans lequel l'étape consistant à déterminer si l'un du premier ou deuxième magnétomètre (102) est potentiellement perturbé par du fer doux comprend en outre les étapes ci-dessous consistant à :

générer une première valeur et une deuxième valeur indiquant un changement d'un champ magnétique pendant une période de détection, sur la base des données reçues en provenance du premier magnétomètre (102) et du deuxième magnétomètre (102), respectivement ;

déterminer une différence de changement du champ magnétique entre la première valeur basée sur le premier magnétomètre (102) et la deuxième valeur basée sur le deuxième magnétomètre (102) ; et

déterminer qu'une grandeur de la différence de changement du champ magnétique dépasse le seuil prédéterminé.

**11.** Procédé selon la revendication 9, comprenant en outre les étapes ci-dessous consistant à :

en réponse à une détermination selon laquelle ni le premier ni le deuxième magnétomètre (102) n'est potentiellement perturbé par du fer doux,

utiliser des données magnétométriques reçues en provenance du premier magnétomètre (102) pour fournir une première valeur de cap afin de calibrer le premier gyroscope de cap (104) associé au premier magnétomètre (102) ; et

utiliser des données magnétométriques reçues en provenance du deuxième magnétomètre (102) pour fournir une deuxième valeur de cap afin de calibrer le deuxième gyroscope de cap (104) associé au deuxième magnétomètre (102) .

**12.** Procédé selon la revendication 9, comprenant en outre les étapes ci-dessous consistant à :

en réponse à une détermination selon laquelle le premier signal de changement dépasse le premier seuil, utiliser une lecture gyroscopique du premier gyroscope de cap (104) pour calibrer le premier magnétomètre (102) associé au premier gyroscope de cap (104) ; et

en réponse à une détermination selon laquelle le deuxième signal de changement dépasse le deuxième seuil, utiliser une lecture gyroscopique du deuxième gyroscope de cap (104) pour calibrer le deuxième magnétomètre (102) associé au deuxième gyroscope de cap (104).

**13.** Procédé selon la revendication 9, comprenant en outre les étapes ci-dessous consistant à :

en réponse à une détermination selon laquelle le premier signal de changement ne dépasse pas le premier seuil, utiliser des données magnétométriques reçues en provenance du premier magnétomètre (102) pour fournir une première valeur de cap permettant de calibrer le premier gyroscope de cap (104) associé au premier magnétomètre (102) ; et

en réponse à une détermination selon laquelle le deuxième signal de changement ne dépasse pas le deuxième seuil, utiliser des données magnétométriques reçues en provenance du deuxième magnétomètre (102) pour fournir une deuxième valeur de cap permettant de calibrer le deuxième gyroscope de cap (104) associé au deuxième magnétomètre (102).

10

READ AND PROCESS
MAGNETOMETER AND GYRO
DATA

12

COMPARE THE CHANGE IN
MAGNETOMETER VALUE WITH
THE CHANGE IN GYRO SINCE
THE LAST READING

14

16

NO

IS THE DIFFERENCE GREATER
THAN THE EXPECTED GYRO DRIFT
OVER THE PERIOD SINCE THE LAST
READING?

YES

22

USE THE
MAGNETOMETER
READING FOR
HEADING

18

USE THE GYRO
CHANGE AND THE
LAST HEADING FOR
HEADING

20

OUTPUT HEADING
VALUE

**FIG. 1**

**FIG. 2**

300

312 → READ AND PROCESS MAGNETOMETER AND GYRO DATA

314 → COMPARE THE CHANGE IN MAGNETOMETER VALUE WITH THE CHANGE IN GYRO SINCE THE LAST READING

316 → IS THE DIFFERENCE GREATER THAN THE EXPECTED GYRO DRIFT OVER THE PERIOD SINCE THE LAST READING?

NO

YES

326 → UPDATE THE CALIBRATION VALUE FOR GYRO USING MAGNETOMETER AND ACCELEROMETER DATA

318 → USE THE GYRO CHANGE AND LAST MAGNETOMETER READING FOR MAGNETOMETER VALUE

320 → UPDATE THE CALIBRATION VALUE FOR THE MAGNETOMETER USING THE DIFFERENCE

322 → OUTPUT CORRECTED GYRO AND MAGNETOMETER VALUES

324 → COMPUTE BEST ESTIMATE OF ATTITUDE AND HEADING

**FIG. 3**

**FIG. 4**

500

**FIG. 5**

600

**FIG. 6**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 22395316
- US 92871515
- US 52989412
- US 9207079 B
- US 59206817
- US 4414753 A
- US 5682335 A
- EP 2677275 A2